(19) **Europäisches Patentamt / European Patent Office / Office européen des brevets**

(11) **EP 2 455 947 B1**

(12) # EUROPEAN PATENT SPECIFICATION

(45) Date of publication and mention
of the grant of the patent:
**15.04.2015 Bulletin 2015/16**

(51) Int Cl.:
***H01B 1/22*** *(2006.01)*   ***H01L 31/0224*** *(2006.01)*

(21) Application number: **11179655.3**

(22) Date of filing: **31.08.2011**

(54) **Conductive paste composition and electrode including the same**

Leitfähige Pastenzusammensetzung und Elektrode damit

Composition de pâte conductrice et électrode l'incluant

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **15.11.2010 KR 20100113515**
**25.02.2011 KR 20110017418**

(43) Date of publication of application:
**23.05.2012 Bulletin 2012/21**

(73) Proprietor: **CHEIL INDUSTRIES INC.**
**Gyeongsangbuk-do (KR)**

(72) Inventor: **Choi, Young Wook**
**Gyeonggi-do (KR)**

(74) Representative: **Michalski Hüttermann & Partner Patentanwälte mbB**
**Speditionstraße 21**
**40221 Düsseldorf (DE)**

(56) References cited:
**EP-A1- 0 546 560    EP-A1- 1 583 107**
**EP-A1- 1 586 604    EP-A2- 0 916 711**

## Description

### Field of the Invention

The present invention relates to a conductive paste composition and an electrode including the same. More particularly, the present invention relates to a conductive paste composition that can be used to form a low temperature-type electrode having high electrical conductivity and low contact resistance to a transparent electrode, and an electrode including the conductive paste composition.

### Description of the Related Art

Heterojunction with intrinsic thin layer (HIT) solar cells and thin-film solar cells use transparent electrodes including indium tin oxide (ITO). These types of solar cells undergo changes in their characteristics at high temperatures. In efforts to overcome such problems, electrode pastes having high electrical conductivity at low temperature have been developed.

Korean Unexamined Patent Publication No. 2004-0030441 discloses a conductive paste composition for forming an electrode with increased electrical conductivity at low temperature which includes ultrafine particles having a size of 10 to 20 nm and particles having a size of 1 to 10 $\mu$m.

Document EP 0 546 560 A1 discloses a thick film copper paste composition. Such a composition comprises copper metal particles which are available either non-flake or flake configuration. It is further disclosed that referring to such a composition in which the copper flake particles are in admixture with non-flake copper particles, the weight ratio of non-flake to flake particles being from 0.05 to 0.9.

Document EP 1 586 604 A1 describes a conductive silver paste and a conductive film formed using the same. The amount of spherical silver powders is preferably in the range of 5 to 30 % referring to the sum of the conductive powders.

Document EP 1 583 107 A1 discloses a conductive paste for forming terminal electrodes of multilayer ceramic electronic parts. Such a paste comprises a spherical conductive powder and a flaky conductive powder. This document discloses that the weight ratio of the spherical powder to the flaky powder is in the range of 5:95 to 95:5.

EP 0 916 711 A2 describes a conductive paste which is described inter alia to exhibit a high thermal conductivity after adhesion and hardening. A conductive paste contains conductive particles, a hardenable resin, and a solvent has mixed therein fine spherical conductive particles.

It is generally known that an electrode of a fired solar cell is formed after an antireflective layer is etched by a glass component present in a conductive paste and the silicon interface reacts with silver (Ag). Accordingly, low contact resistance and low wire resistance arc considered as two important factors in improving the performance of the solar cell electrode. Low contact resistance is needed to efficiently transfer electron-hole pairs inside the solar cell to a finger electrode, and low wire resistance is needed to deliver electricity from the finger electrode to a bus bar electrode without any loss. In the case of a HIT solar cell or a thin-film solar cell including a transparent conductive oxide (TCO) film, the surface contact resistance of the TCO film tends to be influenced by optimum surface contact between the TCO film and a paste.

Under such circumstances, electrode pastes with low wire resistance and low contact resistance are under continuous development in order to increase the efficiency of HIT solar cells and thin-film solar cells including TCO films as well as fired solar cells.

### Summary of the Invention

The present invention relates to a conductive paste composition comprising a conductive powder, a binder resin and a solvent wherein the conductive powder comprises a flake type powder having an average particle diameter (D50) of $\geq$ 1.2 $\mu$m to $\leq$ 3.0 $\mu$m and a spherical powder having an average particle diameter (D50) of $\geq$ 0.2 $\mu$m to $\leq$ 2.0 $\mu$m, determined using a particle size analyzer (CILAS 1064, CILAS Instruments), in a weight ratio of 1:1 to 1:1,5, and the conductive powder and the binder resin are present in a weight ratio of 1:0.04 to 1:0.08.

In an embodiment, the ratio of the average particle diameter (D50) of the flake type powder to the average particle diameter (D50) of the spherical powder may be from 1.4:1 to 2.4:1.

In an embodiment, the flake type powder may have an average particle diameter (D50) of $\geq$ 1.4 $\mu$m to $\leq$ 2.8 $\mu$m, for example, $\geq$ 1.6 $\mu$m to $\leq$ 2.7 $\mu$m.

In an embodiment, the flake type powder may have a tap density of $\geq$ 2.5 g/cm$^3$ to $\leq$ 5.0 g/cm$^3$, for example, $\geq$ 3.0 g/cm$^3$to $\leq$ 4.6 g/cm$^3$.

In an embodiment, the spherical powder may have an average particle diameter (D50) of $\geq$ 0.4 $\mu$m to $\leq$ 1.4 $\mu$m, for example, $\geq$ 0.5 $\mu$m to $\leq$ 1.0 $\mu$m.

The average particle diameter (D50) or the flake type powder may be greater than the average particle diameter (D50) of the spherical powder.

In an embodiment, the conductive powder and the binder resin may be present in a weight ratio of 1:0.05 to 1:0.07, for example, 1:0.06 to 1:0.07.

Another aspect of the present invention provides an electrode including the conductive paste composition.

In an embodiment, the electrode may have a contact resistance of $\geq$ 5 m$\Omega$·cm$^2$ to $\leq$ 65 m$\Omega$·cm$^2$, for example, $\geq$ 7 m$\Omega$·cm$^2$ to $\leq$ 20 m$\Omega$·cm$^2$.

In an embodiment, the electrode may have a wire resistance of $\geq$ 45 $\Omega$/m to $\leq$ 85 $\Omega$/m.

## Detailed description of the Invention

Aspects of the present invention provide a conductive paste composition including a conductive powder, a binder resin and a solvent wherein the conductive powder includes a flake type powder having an average particle diameter (D50) of $\geq$ 1.2 $\mu$m to $\leq$ 3.0 $\mu$m and a spherical powder having an average particle diameter (D50) of $\geq$ 0.2 $\mu$m to $\leq$ 2.0 $\mu$m in a weight ratio of 1:0.4 to 1:2, and the conductive powder and the binder resin are present in a weight ratio of 1:0.04 to 1:0.08.

Any electrically conductive organic or inorganic material may be used for the conductive powder.

Examples of conductive powders suitable for use in the conductive paste composition may include silver (Ag), gold (Au), palladium (Pd), platinum (Pt), copper (Cu), chromium (Cr), cobalt (Co), aluminum (Al), tin (Sn), lead (Pb), zinc (Zn), iron (Fe), iridium (Ir), osmium (Os), rhodium (Rh), tungsten (W), molybdenum (Mo) and nickel (Ni) powders. These conductive powders may be used alone or as a mixture of two or more thereof. The conductive powder may be composed of an alloy of two or more metals selected from the group consisting of silver (Ag), gold (Au), palladium (Pd), platinum (Pt), copper (Cu), chromium (Cr), cobalt (Co), aluminum (Al), tin (Sn), lead (Pb), zinc (Zn), iron (Fe), iridium (Ir), osmium (Os), rhodium (Rh), tungsten (W), molybdenum (Mo) and nickel (Ni). Preferably, the conductive powder includes silver particles and may further include nickel (Ni), cobalt (Co), iron (Fe), zinc (Zn) or copper (Cu) particles.

The conductive powder may include a flake type powder and a spherical powder.

The flake type powder may be planar in the form of a flake or may have a flat shape and is commercially available.

The flake type powder may have an average particle diameter (D50) of $\geq$ 1.2 $\mu$m to $\leq$ 3.0 $\mu$m, for example, $\geq$ 1.4 $\mu$m to $\leq$ 2.8 $\mu$m or $\geq$ 1.6 $\mu$m to $\leq$ 2.7 $\mu$m.

Within this range, the contact resistance of a final electrode is effectively lowered. The flake type powder may have an average particle diameter (D90) of $\geq$ 4.0 $\mu$m to $\leq$ 9.0 $\mu$m, for example, $\geq$ 4.5 $\mu$m to $\leq$ 8.0 $\mu$m or $\geq$ 6.0 $\mu$m to $\leq$ 7.8 $\mu$m. The flake type powder may have an average particle diameter (D10) of $\geq$ 0.5 $\mu$m to $\leq$ 1.0 $\mu$m, for example, $\geq$ 0.7 $\mu$m to $\leq$ 1.0 $\mu$m or $\geq$ 0.6 $\mu$m to $\leq$ 1.0 $\mu$m.

The average particle diameters of the powders were determined using a particle size analyzer (CILAS 1064, CILAS Instruments).

The flake type powder may have a tap density of $\geq$ 2.5 g/cm$^3$ to $\leq$ 5.0 g/cm$^3$, for example, $\geq$ 3.0 g/cm$^3$ to $\leq$ 4.6 g/cm$^3$ or $\geq$ 4.0 g/cm$^3$ to $\leq$ 4.5g/cm$^3$.

The flake type powder may have a specific surface area of $\geq$ 0.5 m$^2$/g to $\leq$ 1.5 m$^2$/g, for example, $\geq$ 0.9 m$^2$/g to $\leq$ 1.3 m$^2$/g or $\geq$ 0.9 m$^2$/g to $\leq$ 1.2 m$^2$/g.

The spherical powder is composed of substantially spherical or elliptical particles and is commercially available.

The spherical powder may have an average particle diameter (D50) of $\geq$ 0.2 $\mu$m to $\leq$ 2.0 $\mu$m, for example, $\geq$ 0.4 $\mu$m to $\leq$ 1.4 $\mu$m or $\geq$ 0.5 $\mu$m to $\leq$ 1.0 $\mu$m. Within this range, the contact resistance of a final electrode is effectively lowered. The spherical powder may have an average particle diameter (D90) of $\geq$ 0.5 $\mu$m to $\leq$ 3.0 $\mu$m, for example, $\geq$ 0.6 $\mu$m to $\leq$ 2.2 $\mu$m or $\geq$ 1.3 $\mu$m to $\leq$ 2.2 $\mu$m. The spherical powder may have an average particle diameter (D10) of $\geq$ 0.2 $\mu$m to $\leq$ 1.2 $\mu$m, for example, $\geq$ 0.2 $\mu$m to $\leq$ 1.0 $\mu$m or $\geq$ 0.2 $\mu$m to $\leq$ 0.4 $\mu$m.

The spherical powder may have a tap density of $\geq$ 4.0 g/cm$^3$ to $\leq$ 5.0 g/cm$^3$, for example, $\geq$ 4.3 g/cm$^3$ to $\leq$ 5.0 g/cm$^3$ or $\geq$ 4.3 g/cm$^3$ to $\leq$ 4.8 g/cm$^3$.

The spherical powder may have a specific surface area of $\geq$ 0.4 m$^2$/g to $\leq$ 1.4 m$^2$/g, for example, $\geq$ 0.6 m$^2$/g to $\leq$ 1.1 m$^2$/g or $\geq$ 0.7 m$^2$/g to $\leq$ 1.1 m$^2$/g.

The conductive powder may include a mixture of flake type powders having different average particle diameters (D50, D90 or D10) or a mixture of spherical powders having different average particle diameters (D50, D90 or D10). In this case, the average particle diameters of the flake type powders may be in the range of $\geq$ 1.6 $\mu$m to $\leq$ 2.7 $\mu$m and those of the spherical powders may be in the range of $\geq$ 0.4 $\mu$m to $\leq$ 0.8 $\mu$m.

The ratio of the average particle diameter (D50) of the flake type powder to the average particle diameter (D50) of the spherical powder may be in the range of 1.4:1 to 2.4:1. Within this range, the contact resistance of a final electrode is effectively lowered.

The flake type powder and the spherical powder may be present in a weight ratio of 1:1 to 1:1.5. The contact resistance of an electrode formed using the composition including the flake type powder and the spherical powder in a weight ratio within the range defined above is considerably lowered, compared to that of an electrode formed using a composition including only one of the flake type powder or the spherical powder.

The flake type powder may be present in an amount of $\geq$ 35 parts by weight to $\leq$ 65 parts by weight, based on 100 parts by weight of the conductive powder. The presence of the flake type powder in an amount of $\geq$ 35 parts by weight to $\leq$ 65 parts by weight is effective in lowering the contact resistance of a final electrode.

The spherical powder may be present in an amount of $\geq$ 35 parts by weight to $\leq$ 65 parts by weight, based on 100 parts by weight of the conductive powder. The presence of the spherical powder in an amount of $\geq$ 35 parts by weight to $\leq$ 65 parts by weight is effective in lowering the contact resistance of a final electrode.

The conductive powder may be present in an amount of $\geq$ 80 wt.-% to $\leq$ 95% by weight, based on the total weight of the conductive paste composition. The presence of the conductive powder in an amount of $\geq$ 80 wt.-% to $\leq$ 95 % by weight is effective in lowering the contact resistance of a final electrode.

The binder resin is added to provide liquid characteristics to the conductive paste composition.

The conductive powder and the binder resin may be present in a weight ratio of 1:0.04 to 1:0.08, for example, 1:0.05 to 1:0.07 or 1:0.06 to 1:0.07. Within this range, the contact resistance of a final electrode is effectively lowered.

The binder resin may be present in an amount of $\geq$ 1wt.-% to $\leq$ 10% by weight, for exanlple, $\geq$ 3 wt.-% to $\leq$ 9% by weight, based on the total weight of the conductive paste composition. The presence of the binder resin in an amount of $\geq$ 1wt.-% to $\leq$ 10% by weight is effective in considerably lowering the contact resistance of a final electrode without causing reliability problems, such as electrode peeling.

The binder resin may have a weight average molecular weight of $\geq$ 100 g/mol to $\leq$ 1,000 g/mol, for example, $\geq$ 150 g/mol to $\leq$ 500 g/mol.

Suitable binder resins include epoxy resins, (meth)acrylic resins, cellulosic resins, ester resins, alkyd resins, butyral resins and PVA resins. For example, the binder resin may be an epoxy resin selected from the group consisting of cresol novolac, bisphenol F, bisphenol A epoxy resins, and mixtures thereof.

The solvent may be any one that is capable of dissolving the binder resin and is miscible with the conductive powder and other additives. For example, the solvent may be one having a boiling point of 200 °C or higher. If the solvent has a boiling point lower than 200 °C, poor printability, such as screen clogging, may be encountered. The solvent may be selected from the group consisting of aliphatic alcohols, ester solvents, carbitol solvents, cellosolve solvents and hydrocarbon solvents, which are commonly used in the production of electrodes. Examples of solvents suitable for use in the conductive paste composition include methyl cellosolve, ethyl cellosolve, butyl cellosolve, aliphatic alcohols, terpineol, ethylene glycol, ethylene glycol monobutyl ether, butyl cellosolve acetate, texanol and butyl carbitol acetate. The solvent may make up the remainder of the conductive paste composition. Specifically, the solvent may be used in an amount of $\geq$ 1 parts by weight to $\leq$ 10 parts by weight, for example, $\geq$ 2 parts by weight to $\leq$ 8 parts by weight, based on 100 parts by weight of the conductive paste composition.

In an embodiment, the flake type powder may have an average particle diameter (D50) of $\geq$ 1.4 $\mu$m to $\leq$ 2.7 $\mu$m, the spherical powder may have an average particle diameter (D50) of $\geq$ 0.4 $\mu$m to $\leq$ 1.4 $\mu$m, the flake type powder and the spherical powder may be present in a weight ratio of 1:1 to 1:1.5, and the conductive powder and the binder resin may be present in a weight ratio of 1:0.06 to 1:0.07. These ranges are effective in lowering the contact resistance of a final electrode.

In an embodiment, the flake type powder may have an average particle diameter (D50) of $\geq$ 1.6 $\mu$m to $\leq$ 2.7 $\mu$m, the spherical powder may have an average particle diameter (D50) of $\geq$ 0.4 $\mu$m to $\leq$ 0.8 $\mu$m, the flake type powder and the spherical powder may be present in a weight ratio of 1:1 to 1:1.5, and the conductive powder and the binder resin may be present in a weight ratio of 1:0.06 to 1:0.07. These ranges are effective in lowering the contact resistance of a final electrode.

The conductive paste composition may further include at least one diluent and/or at least one curing agent.

Suitable diluents for use in the conductive paste composition include, but are not limited to, epoxy compounds such as epoxy (meth)acrylates. The diluent may be used in an amount of $\geq$ 0.1 parts by weight to $\leq$ 5 parts by weight, for example, $\geq$ 0.5 parts by weight to $\leq$ 3 parts by weight, based on 100 parts by weight of the conductive paste composition. The use of the diluent in an amount of $\geq$ 0.1 parts by weight to $\leq$ 5 parts by weight is effective in achieving increased flexibility and reduced resistance of a final electrode.

Examples of curing agents suitable for use in the conductive paste composition include amine curing agents, carboxyhydrazine, imidazole curing agents such as heptadecylimidazole, latent curing agents and modified phenolic resins. The curing agent may be used in an amount of $\geq$ 0.1 parts by weight to $\leq$ 5 parts by weight, for example, $\geq$ 0.2 parts by weight to $\leq$ 3 parts by weight, based on 100 parts by weight of the conductive paste composition.

The conductive paste composition may further include one or more additives selected from the group consisting of glass frits, dispersants, thixotropic agents, viscosity stabilizers, defoaming agents, pigments, UV stabilizers, antioxidants, inorganic fillers and coupling agents. These additives are well known to those skilled in the art and can be commercially purchased.

The conductive paste composition can be used to form electrodes for various electrical/electronic devices.

Other applications of the conductive paste composition include packaging and assembly of electrical/electronic devices. In addition, the conductive paste composition is suitable for the production of electrical/electronic device components by screen printing. As an example, the conductive paste composition is preferably used to form an electrode of a HIT solar cell or a thin-film solar cell that requires low-temperature characteristics and low contact resistance.

Aspects of the present invention provide an electrode including the conductive paste composition. The electrode can be formed by any suitable process known to those skilled in the art. For example, the electrode can be formed by printing the conductive paste composition, followed by curing. The curing temperature may be in the range of $\geq 100$ to $\geq 250$ °C, but is not limited to this range. The electrode may have a contact resistance of $\geq 5$ m$\Omega$.cm$^2$ to $\leq 65$ m$\Omega \cdot$cm$^2$, for example, $\geq 7$ m$\Omega \cdot$cm$^2$ to $\leq 20$ m$\Omega \cdot$cm$^2$. The electrode may have a wire resistance of $\geq 45$ $\Omega$/m to $\leq 85$ $\Omega$/m.

A more detailed description of the present invention will be given with reference to the following examples. Disclosures that are not included herein will be readily recognized and appreciated by those skilled in the art, and thus an explanation thereof is omitted.

## EXAMPLES

Components used in Examples 1-15 and Comparative Examples 1-5 are as follows.
(1) Conductive powders: flake type Ag powders and spherical Ag powders whose physical properties are shown in Table 1.

**TABLE 1**

| Kind | Shape | Tap density (g/cm$^3$) diameter | Average particle (D10, $\mu$m) | Average particle diameter (D50, $\mu$m) | Average particle diameter (D90, $\mu$m) | Specific surface area (m$^2$/g) | Manufacturer | Grade |
|---|---|---|---|---|---|---|---|---|
| powder 1 | Spherical | 4.0 | 0.2 | 0.4 | 0.6 | 1.4 | Heesung Metal Co., Ltd. (Korea) | HP0704 |
| powder 2 | Spherical | 4.3 | 0.4 | 0.8 | 1.3 | 1.1 | Dowa | 2-1C |
| powder 3 | Spherical | 5.0 | 1.0 | 1.4 | 2.2 | 0.7 | Dowa | 3-11F |
| powder 4 | Spherical | 4.8 | 1.2 | 1.8 | 2.8 | 0.6 | Dowa | 4-11F |
| powder 5 | Spherical | 4.8 | 1.6 | 2.8 | 4.3 | 0.4 | Dowa | 5-11F |
| powder 6 | Flake | 2.5 | 0.7 | 1.6 | 4.1 | 4.6 | Dowa | S-2 |
| powder 7 | Flake | 5.0 | 0.6 | 1.4 | 5.6 | 1.2 | Dowa | S-1 |
| powder 8 | Flake | 3.3 | 1.0 | 2.7 | 7.36 | 1.3 | Heesung Metal Co., Ltd. (Korea) | HP0202E |
| powder 9 | Flake | 3.9 | 0.9 | 3.0 | 7.76 | 0.9 | Techmc | F241 |
| powder 10 | Flake | 4.6 | 1.9 | 3.9 | 9.3 | 0.5 | Dowa | D-1 |

(2) Binder resin: A mixture of a cresol novolac resin (YDCN-90P, Kukdo Chemical Co., Ltd. (Korea)) ("Epoxy resin I") and a bisphenol F resin (YDF-170, Kukdo Chemical Co., Ltd. (Korea)) ("Epoxy resin 2")
(3) Diluent: An epoxy acrylate resin (EA-5521, Shin-Nakamura Chemical Co., Ltd.)
(4) Solvent: Butyl carbitol acetate (BCA)
(5) Curing agent: 2-Undecylimidazole (C11Z, SHIKOKU Chemical)

Conductive paste compositions were prepared as shown in Tables 2-5. Each of the conductive paste compositions was rolled using a scraper on a screen plate and was then printed while being ejected using a squeezer to an image area of the screen plate, followed by curing at 200 °C for 40 min to form an electrode. The electrode was patterned to have a size of 1 cm (length) x 200 $\mu$m (width), and the contact resistance and the wire resistance of the pattern were measured. The results are shown in Tables 2-5.

* Contact resistance measurement:

10 resistance values of the pattern were measured at intervals of 0.03 cm between 0.03 cm and 0.3 cm. The resistance values were plotted. From the graph, the slope, $R_c$ and $L_T$ values were obtained. The specific contact resistance ($\rho_c$) of the electrode was given by substituting the obtained values into the following equation.

$$\rho_c = R_c \times L_T \times Z \times TANH\ (L/L_T)$$

where L and Z represent the area and length of the electrode, respectively.
The above equation was introduced in H. H. Berger "Models for contacts to planar devices" Solid State Electronics Vol. 15 p. 145 (1972).

* Wire resistance measurement:

The electrode was patterned to have a width of 100 $\mu$m and a length of 10 cm. The resistance of the pattern was measured using a multimeter. The obtained value was converted into a value per 1 meter length.

**TABLE 2**

| Conductive paste composition | Flake type powder 3 | Flake type powder 4 | Spherical powder 2 | Epoxy resin 1 | Epoxy resin 2 | Diluent | Curing agent | Solvent | Weight ratio* | Contact resistance (MΩ·cm$^2$) | Wire resistance (Ω/M) |
|---|---|---|---|---|---|---|---|---|---|---|---|
| Example 1 | 22.2 | 22.2 | 44.6 | 1.4 | 4.8 | 1.5 | 0.3 | 3 | 1:0.0697 | 30.03 | 60.83 |
| Example 2 | 22.5 | 22.5 | 45 | 1.4 | 3.8 | 1.5 | 0.3 | 3 | 1:0.0578 | 18.02 | 49.17 |
| Example 3 | 22.8 | 22.8 | 45.4 | 1.4 | 2.8 | 1.5 | 0.3 | 3 | 1:0.0462 | 15.23 | 43 |
| Comparative Example 1 | 21.9 | 21.9 | 44.2 | 1.4 | 5.8 | 1.5 | 0.3 | 3 | 1:0.0818 | 48.38 | 72.92 |

* represents the weight ratio of the conductive powder to the sum of epoxy resins 1 and 2.

EP 2 455 947 B1

As can be seen from the results in Table 2, the conductive paste compositions of Examples 1-3, each including the conductive powder and the binder resin in a weight ratio within the range defined above, were effective in considerably reducing the contact resistance values of the respective electrodes.

**TABLE 3**

| Conductive paste composition | Flake type powder | | Spherical powder | | Epoxy resin 1 | Epoxy resin 2 | Diluent | Curing agent | Solvent | Contact resistance (mΩcm$^2$) | Wire resistance (Ω/m) |
|---|---|---|---|---|---|---|---|---|---|---|---|
| | Size (D50, μm) | Content | Size (D50, μm) | Content | | | | | | | |
| Example 5 | 2.7 | 54 | 0.8 | 36 | 1.4 | 3.8 | 1.5 | 0.3 | 3 | 5.53 | 49.25 |
| Example 6 | 1.4 | 54 | 0.8 | 36 | 1.4 | 3.8 | 1.5 | 0.3 | 3 | 2.57 | 55.18 |
| Example 7 | 1.6 | 54 | 0.8 | 36 | 1.4 | 3.8 | 1.5 | 0.3 | 3 | 1.52 | 70.14 |
| Comparative Example 2 | 3.9 | 54 | 0.8 | 36 | 1.4 | 3.8 | 1.5 | 0.3 | 3 | 32.32 | 55.15 |

The results in Table 3 show that the conductive paste compositions of Examples 4-7, each including the flake type powder having a size within the range defined above, were effective in considerably reducing the contact resistance values of the respective electrodes.

**TABLE 4**

| Conductive paste composition | Flake type powder | | Spherical powder | | Epoxy resin 1 | Epoxy resin 2 | Diluent | Curing agent | Solvent | Contact resistance (mΩcm²) | Wire resistance (Ω/m) |
|---|---|---|---|---|---|---|---|---|---|---|---|
| | Size (D50, μm) | Content | Size (D50, μm) | Content | | | | | | | |
| Example 8 | 2.7 | 54 | 1.8 | 36 | 1.4 | 3.8 | 1.5 | 0.3 | 3 | 64.88 | 49.50 |
| Example 9 | 2.7 | 54 | 1.4 | 36 | 1.4 | 3.8 | 1.5 | 0.3 | 3 | 15.61 | 52.20 |
| Example 10 | 2.7 | 54 | 0.8 | 36 | 1.4 | 3.8 | 1.5 | 0.3 | 3 | 5.53 | 49.25 |
| Example 11 | 2.7 | 54 | 0.4 | 36 | 1.4 | 3.8 | 1.5 | 0.3 | 3 | 1.94 | 80.1 |
| Comparative Example 3 | 2.7 | 54 | 2.8 | 36 | 1.4 | 3.8 | 1.5 | 0.3 | 3 | 74.16 | 47.35 |

The results in Table 4 show that the conductive paste compositions of Examples 8-11, each including the spherical powder having a size within the range defined above, were effective in considerably reducing the contact resistance values of the respective electrodes.

**TABLE 5**

| Paste | Flake type powder Size (D50, μm) | Content | Spherical powder Size (D50, μm) | Content | Epoxy resin 1 | Epoxy resin 2 | Diluent | Curing agent | Solvent | Weight ratio* | Contact resistance (mΩcm$^2$) | Wire resistance (Ω/m) |
|---|---|---|---|---|---|---|---|---|---|---|---|---|
| Example 12 | 2.7 | 63 | 0.8 | 27 | 1.4 | 3.8 | 1.5 | 0.3 | 3 | 1:0.43 | 15.45 | 47.08 |
| Example 13 | 2.7 | 54 | 0.8 | 36 | 1.4 | 3.8 | 1.5 | 0.3 | 3 | 1:0.67 | 5.53 | 49.25 |
| Example 14 | 2.7 | 45 | 0.8 | 45 | 1.4 | 3.8 | 1.5 | 0.3 | 3 | 1:1 | 2.75 | 54.17 |
| Example 15 | 2.7 | 36 | 0.8 | 54 | 1.4 | 3.8 | 1.5 | 0.3 | 3 | 1:1.5 | 9.64 | 82.08 |
| Comparative Example 4 | 2.7 | 90 | 0.8 | 0 | 1.4 | 3.8 | 1.5 | 0.3 | 3 | - | Impossible to prepare pastes | |
| Comparative Example 5 | 2.7 | 0 | 0.8 | 90 | 1.4 | 3.8 | 1.5 | 0.3 | 3 | - | 1.0 | 148.2 |

* represents the weight ratio of the flake type powder to the spherical powder.

The results in Table 5 show that the conductive paste compositions of Examples 12-15, each including the flake type powder and the spherical powder in a weight ratio within the range defined above, were effective in considerably reducing the contact resistance values of the respective electrodes.

**Claims**

1. A conductive paste composition comprising a conductive powder, a binder resin and a solvent wherein the conductive powder comprises a flake type powder having an average particle diameter (D50) of $\geq 1.2$ $\mu$m to $\leq 3.0$ $\mu$m and a spherical powder having an average particle diameter (D50) of $\geq 0.2$ $\mu$m to $\leq 2.0$ $\mu$m, determined using a particle size analyzer (CILAS 1064, CILAS Instruments), in a weight ratio of 1:1 1 to 1:1,5, and the conductive powder and the binder resin are present in a weight ratio of 1:0.04 to 1:0.08.

2. The conductive paste composition according to claim 1, wherein the flake type powder has an average particle diameter (D50) of $\geq 1.4$ $\mu$m to $\leq 2.8$ $\mu$m.

3. The conductive paste composition according to claim 1 or 2, wherein the flake type powder has a tap density of $\geq 2.5$ g/cm$^3$ to $\leq 5.0$ g/cm$^3$.

4. The conductive paste composition according to claims 1 to 3, wherein the spherical powder has an average particle diameter (D50) of $\geq 0.4$ $\mu$m to $\leq 1.4$ $\mu$m.

5. The conductive paste composition according to claims 1 to 4, wherein the average particle diameter (D50) of the flake type powder is greater than the average particle diameter (D50) of the spherical powder.

6. The conductive paste composition according to claims 1 to 5, wherein the ratio of the average particle diameter (D50) of the flake type powder to the average particle diameter (D50) of the spherical powder is from 1.4:1 to 2.4:1.

7. The conductive paste composition according to claims 1 to 6, wherein the conductive powder is a mixture of the flake type powder and the spherical powder having different average particle diameters.

8. The conductive paste composition according to claims 1 to 7, wherein the conductive powder and the binder resin are present in a weight ratio of 1:0.05 to 1:0.07.

9. The conductive paste composition according to claims 1 to 8, wherein the flake type powder has an average particle diameter (D50) of $\geq 1.6$ $\mu$m to $\leq 2.7$ $\mu$m, the spherical powder has an average particle diameter (D50) of $\geq 0.5$ $\mu$m to $\leq 1.0$ $\mu$m, the flake type powder and the spherical powder are present in a weight ratio of 1:1 to 1:1.5, and the conductive powder and the binder resin are present in a weight ratio of 1:0.06 to 1:0.07.

10. The conductive paste composition according to claims 1 to 9, wherein the conductive paste composition comprises 1 to 10% by weight of the binder resin, 80 to 95% by weight of the conductive powder and the balance of the solvent.

11. The conductive paste composition according to claims 1 to 10, wherein the solvent is included in a balance amount.

12. The conductive paste composition according to claims 1 to 11, wherein the binder resin is selected from the group consisting of an epoxy resin, an acrylic resin, a (meth)acrylic resin, a cellulosic resin, an ester resin, an alkyd resin, a butyral resin, a PVA resin, and mixtures thereof.

13. The conductive paste composition according to claims 1 to 12, wherein the epoxy resin is selected from the group consisting of cresol novolac, bisphenol F, bisphenol A epoxy resins, and mixtures thereof.

14. The conductive paste composition according to claims 1 to 13, further comprising at least one diluent and/or at least one curing agent.

15. An electrode comprising the conductive paste composition according to any of claims 1 to 14.

16. The electrode according to claim 15, wherein the electrode has a contact resistance of $\geq 5$ m$\Omega \cdot$cm$^2$ to $\leq 65$ m$\Omega \cdot$cm$^2$.

17. The electrode according to claim 15, wherein the electrode has a wire resistance of $\geq 45\ \Omega/m$ to $\leq 85\ \Omega/m$.

**Patentansprüche**

1. Leitpastenzusammensetzung, die ein leitfähiges Pulver, ein Trägerharz und ein Lösungsmittel umfasst, wobei das leitfähige Pulver ein plättchenartiges Pulver umfasst, welches einen durchschnittlichen Teilchendurchmesser (D50) von $\geq 1{,}2\ \mu m$ bis $\leq 3{,}0\ \mu m$ hat, und ein kugeliges Pulver umfasst, das einen durchschnittlichen Teilchendurchmesser (D50) von $\geq 0{,}2\ \mu m$ bis $\leq 2{,}0\ \mu m$ hat, bestimmt unter Verwendung eines Teilchengrößenanalysators (CILAS 1064, CILAS Instruments), in einem Gewichtsverhältnis von 1:1 bis 1:1,5, und wobei das leitfähige Pulver und das Trägerharz in einem Gewichtsverhältnis von 1:0,04 bis 1:0,08 vorhanden sind.

2. Leitpastenzusammensetzung nach Anspruch 1, wobei das plättchenartige Pulver einen durchschnittlichen Teilchendurchmesser (D50) von $\geq 1{,}4\ \mu m$ bis $\leq 2{,}8\ \mu m$ hat.

3. Leitpastenzusammensetzung nach Anspruch 1 oder 2, wobei das plättchenartige Pulver eine Klopfdichte von $\geq 2{,}5$ g/cm$^3$ bis $\leq 5{,}0$ g/cm$^3$ hat.

4. Leitpastenzusammensetzung nach Anspruch 1 bis 3, wobei das kugelige Pulver einen durchschnittlichen Teilchendurchmesser (D50) von $\geq 0{,}4\ \mu m$ bis $\leq 1{,}4\ \mu m$ hat.

5. Leitpastenzusammensetzung nach einem der Ansprüche 1 bis 4, wobei der durchschnittliche Teilchendurchmesser (D50) des plättchenartigen Pulvers größer als der durchschnittliche Teilchendurchmesser (D50) des kugeligen Pulvers ist.

6. Leitpastenzusammensetzung nach einem der Ansprüche 1 bis 5, wobei das Verhältnis des durchschnittlichen Teilchendurchmessers (D50) des plättchenartigen Pulvers zum durchschnittlichen Teilchendurchmesser (D50) des kugeligen Pulvers 1,4:1 bis 2,4:1 beträgt.

7. Leitpastenzusammensetzung nach einem der Ansprüche 1 bis 6, wobei das leitfähige Pulver eine Mischung des plättchenartigen Pulvers und des kugeligen Pulvers ist, die unterschiedliche durchschnittliche Teilchendurchmesser haben.

8. Leitpastenzusammensetzung nach einem der Ansprüche 1 bis 7, wobei das leitfähige Pulver und das Trägerharz in einem Gewichtsverhältnis von 1:0,05 bis 1:0,07 vorhanden sind.

9. Leitpastenzusammensetzung nach einem der Ansprüche 1 bis 8, wobei das plättchenartige Pulver einen durchschnittlichen Teilchendurchmesser (D50) von $\geq 1{,}6\ \mu m$ bis $\leq 2{,}7\ \mu m$ hat, das kugelige Pulver einen durchschnittlichen Teilchendurchmesser (D50) von $\geq 0{,}5\ \mu m$ bis $\leq 1{,}0\ \mu m$ hat, das plättchenartige Pulver und das kugelige Pulver in einem Gewichtsverhältnis von 1:1 bis 1:1,5 vorhanden sind und das leitfähige Pulver und das Trägerharz in einem Gewichtsverhältnis von 1:0,06 bis 1:0,07 vorhanden sind.

10. Leitpastenzusammensetzung nach einem der Ansprüche 1 bis 9, wobei die Leitpastenzusammensetzung 1 bis 10 Gew-% des Trägerharzes, 80 bis 95 Gew-% des leitfähigen Pulvers und den Rest an Lösungsmittel umfasst.

11. Leitpastenzusammensetzung nach einem der Ansprüche 1 bis 10, wobei das Lösungsmittel in einer Ausgleichsmenge enthalten ist.

12. Leitpastenzusammensetzung nach einem der Ansprüche 1 bis 11, wobei das Trägerharz aus der Gruppe bestehend aus einem Epoxidharz, einem Acrylharz, einem (Meth)acrylharz, einem Zelluloseharz, einem Esterharz, einem Alkydharz, einem Butyralharz, einem PVA-Harz und Mischungen derselben ausgewählt wird.

13. Leitpastenzusammensetzung nach einem der Ansprüche 1 bis 12, wobei das Epoxidharz aus der Gruppe bestehend aus Cresol-Novolac, Bisphenol F, Bisphenol A-Epoxidharzen und Mischungen derselben ausgewählt wird.

14. Leitpastenzusammensetzung nach einem der Ansprüche 1 bis 13, die ferner mindestens ein Verdünnungsmittel und/oder mindestens ein Härtungsmittel umfasst.

**15.** Elektrode, die die Leitpastenzusammensetzung nach einem der Ansprüche 1 bis 14 umfasst.

**16.** Elektrode nach Anspruch 15, wobei die Elektrode einen Kontaktwiderstand von $\geq 5$ m$\Omega$·cm$^2$ bis $\leq 65$ m$\Omega$·cm$^2$ hat.

**17.** Elektrode nach Anspruch 15, wobei die Elektrode einen Drahtwiderstand von $\geq 45$ $\Omega$/m bis $\leq 85$ $\Omega$/m hat.

**Revendications**

**1.** Composition de pâte conductrice comprenant une poudre conductrice, une résine liante et un solvant, la poudre conductrice comprenant une poudre de type paillettes ayant un diamètre moyen de particules (D50) de $\geq 1,2$ $\mu$m à $\leq 3,0$ $\mu$m et une poudre sphérique ayant un diamètre moyen de particules (D50) de $\geq 0,2$ $\mu$m à $\leq 2,0$ $\mu$m, déterminés en utilisant un analyseur de taille de particules (CILAS 1064, CILAS Instruments), dans un rapport pondéral de 1:1 à 1:1,5, et la poudre conductrice et la résine liante étant présentes dans un rapport pondéral de 1:0,04 à 1:0,08.

**2.** Composition de pâte conductrice selon la revendication 1, dans laquelle la poudre de type paillettes a un diamètre moyen de particules (D50) de $\geq 1,4$ $\mu$m à $\leq 2,8$ $\mu$m.

**3.** Composition de pâte conductrice selon la revendication 1 ou 2, dans laquelle la poudre de type paillettes a une densité tassée de $\geq 2,5$ g/cm$^3$ à $\leq 5,0$ g/cm$^3$.

**4.** Composition de pâte conductrice selon les revendications 1 à 3, dans laquelle la poudre sphérique a un diamètre moyen de particules (D50) de $\geq 0,4$ $\mu$m à $\leq 1,4$ $\mu$m.

**5.** Composition de pâte conductrice selon les revendications 1 à 4, dans laquelle le diamètre moyen de particules (D50) de la poudre de type paillettes est supérieur au diamètre moyen de particules (D50) de la poudre sphérique.

**6.** Composition de pâte conductrice selon les revendications 1 à 5, dans laquelle le rapport entre le diamètre moyen de particules (D50) de la poudre de type paillettes et le diamètre moyen de particules (D50) de la poudre sphérique est de 1,4:1 à 2,4:1.

**7.** Composition de pâte conductrice selon les revendications 1 à 6, dans laquelle la poudre conductrice est un mélange de la poudre de type paillettes et de la poudre sphérique ayant différents diamètres moyens de particules.

**8.** Composition de pâte conductrice selon les revendications 1 à 7, dans laquelle la poudre conductrice et la résine liante sont présentes dans un rapport pondéral de 1:0,05 à 1:0,07.

**9.** Composition de pâte conductrice selon les revendications 1 à 8, dans laquelle la poudre de type paillettes a un diamètre moyen de particules (D50) de $\geq 1,6$ $\mu$m à $\leq 2,7$ $\mu$m, la poudre sphérique a un diamètre moyen de particules (D50) de $\geq 0,5$ $\mu$m à $\leq 1,0$ $\mu$m, la poudre de type paillettes et la poudre sphérique sont présentes dans un rapport pondéral de 1:1 à 1:1,5, et la poudre conductrice et la résine liante sont présentes dans un rapport pondéral de 1:0,06 à 1:0,07.

**10.** Composition de pâte conductrice selon les revendications 1 à 9, la composition de pâte conductrice comprenant 1 à 10 % en poids de la résine liante, 80 à 95 % en poids de la poudre conductrice et le complément du solvant.

**11.** Composition de pâte conductrice selon les revendications 1 à 10, dans laquelle le solvant est inclus dans une quantité de complément.

**12.** Composition de pâte conductrice selon les revendications 1 à 11, dans laquelle la résine liante est choisie dans le groupe constitué par une résine époxyde, une résine acrylique, une résine (méth)acrylique, une résine cellulosique, une résine d'ester, une résine alkyde, une résine de butyral, une résine de PVA, et les mélanges de celles-ci.

**13.** Composition de pâte conductrice selon les revendications 1 à 12, dans laquelle la résine époxyde est choisie dans le groupe constitué par les résines époxydes de crésol-novolaque, bisphénol F, bisphénol A, et les mélanges de celles-ci.

**14.** Composition de pâte conductrice selon les revendications 1 à 13, comprenant en outre au moins un diluant et/ou au moins un durcisseur.

**15.** Électrode comprenant la composition de pâte conductrice selon l'une quelconque des revendications 1 à 14.

**16.** Électrode selon la revendication 15, l'électrode ayant une résistance de contact de $\geq 5$ m$\Omega\cdot$cm$^2$ à $\leq 65$ m$\Omega\cdot$cm$^2$.

**17.** Électrode selon la revendication 15, l'électrode ayant une résistance de fil de $\geq 45$ $\Omega$/m à $\leq 85$ $\Omega$/m.

**REFERENCES CITED IN THE DESCRIPTION**

**Patent documents cited in the description**

- KR 20040030441
- EP 0546560 A1
- EP 1586604 A1
- EP 1583107 A1
- EP 0916711 A2

**Non-patent literature cited in the description**

- **H. H. BERGER.** Models for contacts to planar devices. *Solid State Electronics,* 1972, vol. 15, 145